(19) Europäisches Patentamt
European Patent Office
Office européen des brevets

(11) **EP 3 108 558 B1**

(12) **EUROPEAN PATENT SPECIFICATION**

(45) Date of publication and mention of the grant of the patent:
**31.05.2023   Bulletin 2023/22**

(21) Application number: **15704625.1**

(22) Date of filing: **15.01.2015**

(51) International Patent Classification (IPC):
**H02H 5/12** *(2006.01)*    **H02H 1/00** *(2006.01)*
**H02H 7/22** *(2006.01)*    **B23Q 11/00** *(2006.01)*

(52) Cooperative Patent Classification (CPC):
**H02H 1/0015; H02H 5/12; H02H 7/22**

(86) International application number:
**PCT/US2015/011545**

(87) International publication number:
**WO 2015/126540 (27.08.2015 Gazette 2015/34)**

(54) **DISPLAY DEVICE FOR CALCULATION AND DISPLAY OF ARC FLASH INCIDENT ENERGY**

ANZEIGEVORRICHTUNG ZUR BERECHNUNG UND ANZEIGE VON LICHTBOGENEINFALLSENERGIE

DISPOSITIF D'AFFICHAGE POUR LE CALCUL ET L'AFFICHAGE DE L'ÉNERGIE INCIDENTE D'UN ÉCLAIR D'ARC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   **18.02.2014   US 201414182522**

(43) Date of publication of application:
**28.12.2016   Bulletin 2016/52**

(73) Proprietor: **Eaton Intelligent Power Limited Dublin 4 (IE)**

(72) Inventors:
• **LAGREE, James L.**
  **Robinson Township, Pennsylvania 15136 (US)**
• **BENZING, Joel E.**
  **Arden, North Carolina 28704 (US)**
• **ROGAN, Christopher A.**
  **Brightwaters, New York 11718-1403 (US)**
• **BARNES, Rufus L.**
  **Cranberry Township, Pennsylvania 16066 (US)**
• **RICCIUTI, Anthony T.**
  **Bethel Park, Pennsylvania 15102 (US)**

(74) Representative: **Novagraaf Group**
  **Chemin de l'Echo 3**
  **1213 Onex (CH)**

(56) References cited:
EP-A2- 2 662 942        US-A1- 2008 036 472
US-A1- 2009 105 998     US-A1- 2011 128 005

**Description**

BACKGROUND

Field

The disclosed concept pertains generally to electrical distribution apparatus, such as switchgear and panelboards, and, more particularly, to devices that indicate arc flash incident energy of such electrical distribution apparatus.

Background Information

The National Fire Protection Association (NFPA) standard NFPA 70E-Standard for Electrical Safety in the Workplace (2009) defines Arc Flash Hazard as being a dangerous condition associated with the possible release of energy caused by an electric arc. The standard also defines Arc Flash Hazard Analysis as being a study investigating a worker's potential exposure to arc flash energy, conducted for the purpose of injury prevention and the determination of safe work practices, arc flash protection boundary, and the appropriate levels of Personal Protective Equipment (PPE) that a worker would have to wear to protect against the level of incident energy that is released if there should be an incident creating an arc flash.

For arc flash protection, NFPA 70 110.16 and NFPA 70E 400.11 require that switchboards, panelboards, industrial control panels, meter socket enclosures, and motor control centers that are in other than dwelling occupancies and are likely to require examination, adjustment, servicing or maintenance while energized be field marked to warn qualified persons of potential electric arc flash hazards. The marking shall be located so as to be clearly visible to qualified persons before examination, adjustment, servicing or maintenance of the equipment.

A known process of evaluating an available fault current, an incident energy and a PPE level (e.g., without limitation, gloves; flame retardant garments) for a particular power system is for an engineer to perform theoretical calculations using power system parameters. A known approach to analyze the incident arc flash of electrical distribution equipment involves an engineer reviewing the equipment and a one line diagram of the corresponding power distribution system and using IEEE 1584 standard calculations and the NFPA 70E standard to assign a value of arc flash incident energy for particular pieces of distribution equipment listed in the one line diagram. Then, based on the calculations, a printed label is affixed to the power system equipment stating the manually calculated available fault current, the manually calculated incident energy and the manually calculated PPE level. There is, however, no known way to verify the correctness of this static information. There is further the risk that if the power system is modified, the manually calculated available fault current, the manually calculated incident energy and the manually calculated PPE level will change, but the printed label will not be timely changed, if at all.

U.S. Pat. No. 8,493,012 discloses an electrical switching apparatus, such as a medium voltage motor starter, that determines fault current available at a medium voltage motor and displays that available fault current along with a number of incident energy at medium voltage motor starter, and PPE level required by operators or maintenance personnel assigned to operate or maintain the medium voltage motor starter.

There are, however, many factors in the arc flash incident energy value that change when parameters in the system change.

There is room for improvement in devices that calculate and display arc flash incident energy.

US 2009/105998 A discloses a method for simulating an arc flash event on an electrical power system. A virtual system model of the electrical system is modified to introduce a short circuiting feature.

EP 2 662 942 A discloses a systems for activation of a protection system and dynamic labeling. An example system for use with a plurality of circuit protection devices coupled to a switchgear unit includes a first sensor for detecting a body located within a first zone associated with a threshold distance from the switchgear unit, and a controller coupled to the first sensor. The controller is configured to selectively enable the plurality of circuit protection devices. The controller is configured to enable a first circuit protection device of the plurality of circuit protection devices in response to detecting, via the first sensor, a body within the first zone.

Further, US 2008 036 472 A1 is related to an Impedance-based Arc-Fault Determination Device (IADD) and method that, when attached to an electrical node on the power system and through observations on voltage, current and phase shift with a step load change, determine the effective Thevenin equivalent circuit or Norton equivalent circuit at the point of test.

SUMMARY

These needs and others are met by embodiments of the disclosed concept in which incident energy of a power circuit zone is calculated employing dynamic inputs and the calculated incident energy is displayed.

In accordance with the present invention, a display device as set forth in claim 1 is provided. Further embodiments are inter alia disclosed in the dependent claims.

BRIEF DESCRIPTtON OF THE DRAWINGS

A. full understanding of the disclosed concept can be gained from the following description of the preferred embodiments when read in conjunction with the accompanying drawings in which:
The scope as recited in the appended claims is limited to a display device and not a meter.

Figure 1 is a block diagram of switchgear including a meter or display device to calculate and display arc flash incident energy for the switchgear in accordance with embodiments of the disclosed concept.
Figure 2 is a block diagram of a system including a meter or display device to display a one line diagram of an electrical distribution system and to calculate and display arc flash incident energy at plural different locations on the diagram for the system in accordance with another embodiment of the disclosed concept
Figure 3 is a representation of the one line diagram of Figure 2 displaying plural calculated are flash incident energy values from a plurality of meter of display devices distributed throughout the electrical distribution system.
Figures 4A-4D are flowcharts of routines executed by the meter or display device of Figure 1.
Figure 5 is a representation of a portion of a one line diagram similar to a portion of the one line diagram of Figure 2 except showing a circuit breaker in an Arc Reduction Maintenance System (ARMS) mode and the display showing a relatively lower value of potential incident energy and an area of the electrical distribution system being protected.
Figure 6 is a representation of a portion of a one line diagram similar to a portion of the one line diagram of Figure 2 except showingan area of the electrical distribution system that has Zone Selective Interlocking (ZSI) enabled and the displays are showing relatively lower values of potential incident energy and the area of the system being protected.
Figure 7 is a representation of a portion of a one line diagram similar to a portion of the one line diagram of Figure 2 except showing an area of the electrical distribution system that has a circuit breaker that is opened and the display is showing a relatively lower value of potential incident energy and the area of the system being protected.
Figure 8 is a representation of a one line diagram similar to the one line diagram of Figure 2 except showing a generator that is turned on and a corresponding circuit breaker and tie circuit breaker are closed and paralleled with a utility feed and the displays are showing relatively higher values of potential incident energy throughout the electrical distribution system because of the added contribution of energy by the generator.
Figure 9 is an isometric view of switchgear including a meter or display device having a personnel distance sensor in accordance with another embodiment of the disclosed concept.
Figure 10 is an isometric view of switchgear including a plurality of doors and door sensors for the doors in accordance with another embodiment of the disclosed concept.
Figure 11 is a block diagram in schematic form of the meter or display device of Figure 1.

DESCRIPTION OF THE PREFERRED EMBODIMENTS

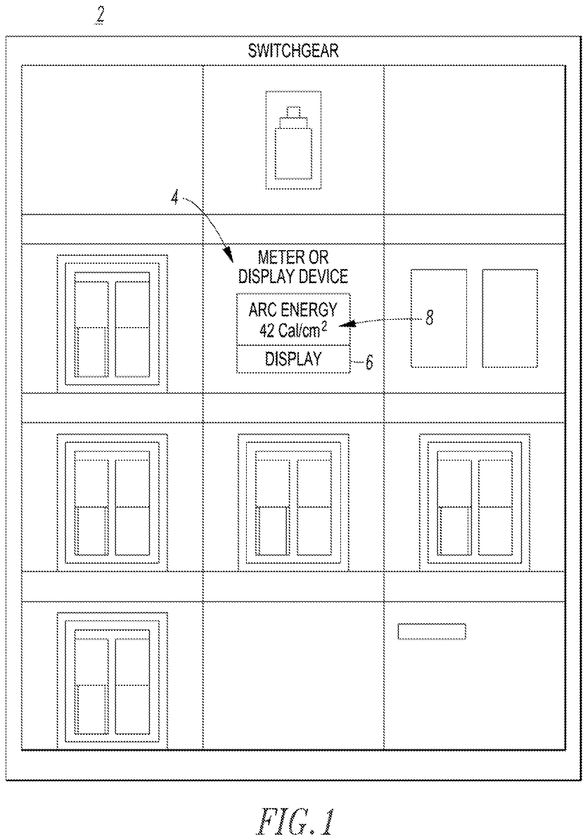

As employed herein, the term "number" shall mean one or an integer greater than one (*i.e.*, a plurality).
As employed herein, the term "processor" shall mean a programmable analog and/or digital device that can store, retrieve, and process data; a computer; a workstation; a personal computer; a controller, a digital signal processor; a microprocessor; a microcontroller; a microcomputer; a central processing unit; a mainframe computer; a mini-computer; a server; a networked processor; or any suitable processing device or apparatus.
Referring to Figure 1, switchgear 2 is shown including a meter or display device 4 to calculate and display arc flash incident energy for the switchgear 2. A display 6 displays a dynamic value 8 representing the calculated incident energy.

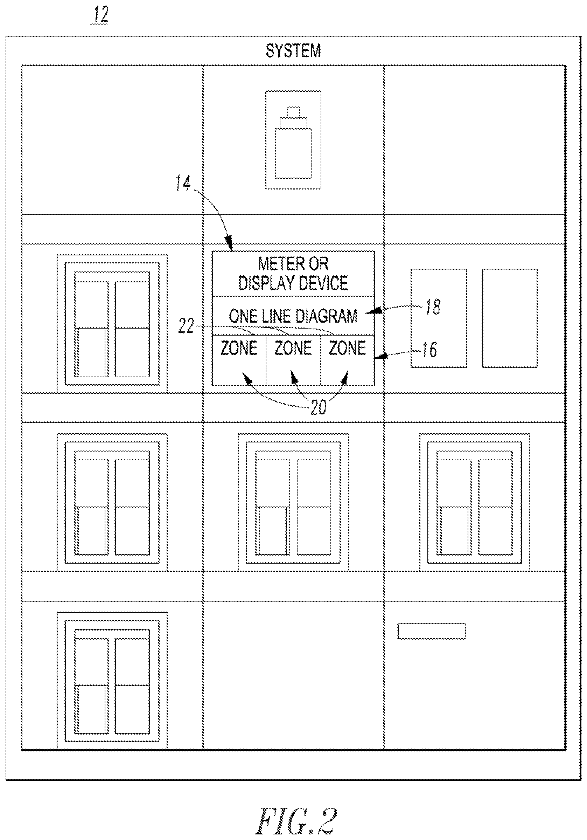

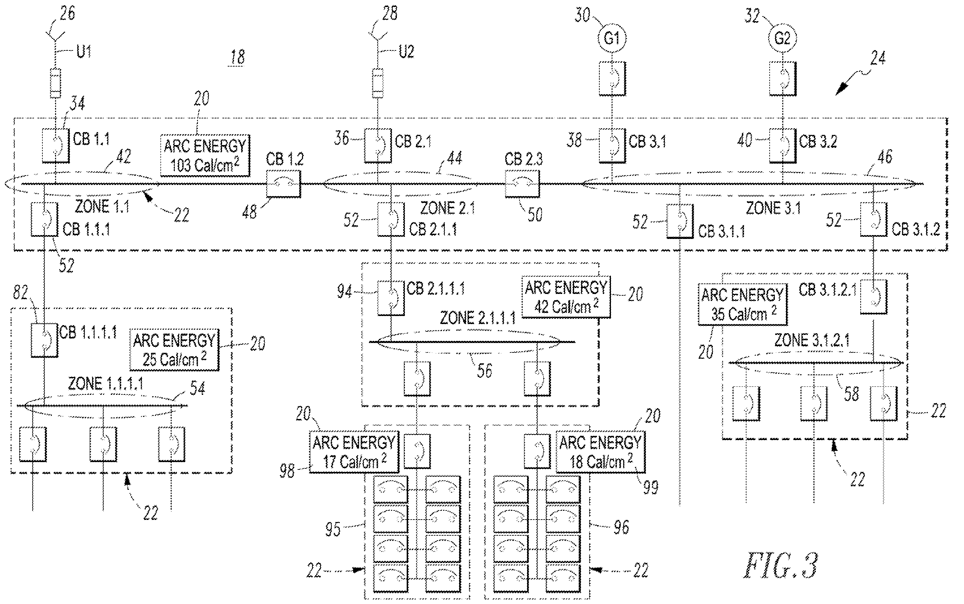

Figure 2 shows a system 12 including another meter or display device 14, which may be the same as or similar to the device 4 of Figure 1. The device 14 includes a display 16 that displays a one line diagram 18 (best shown in Figure 3) of an electrical distribution system. The device 14 calculates and displays plural different dynamic arc flash incident energy values 20 at a number of different locations 22 (e.g., zones) of the system 12. The device 14 can advantageously be located at any suitable location in a building or system. For example and without limitation, displaying the one line diagram 18 of Figure 2 may be a mode of operation of the device 4 of Figure 1 (which can also display the dynamic value 8 for a particular location). The one line diagram 18 may display a representation of a plurality of different power circuit zones as the number of different locations 22 of the system 12.

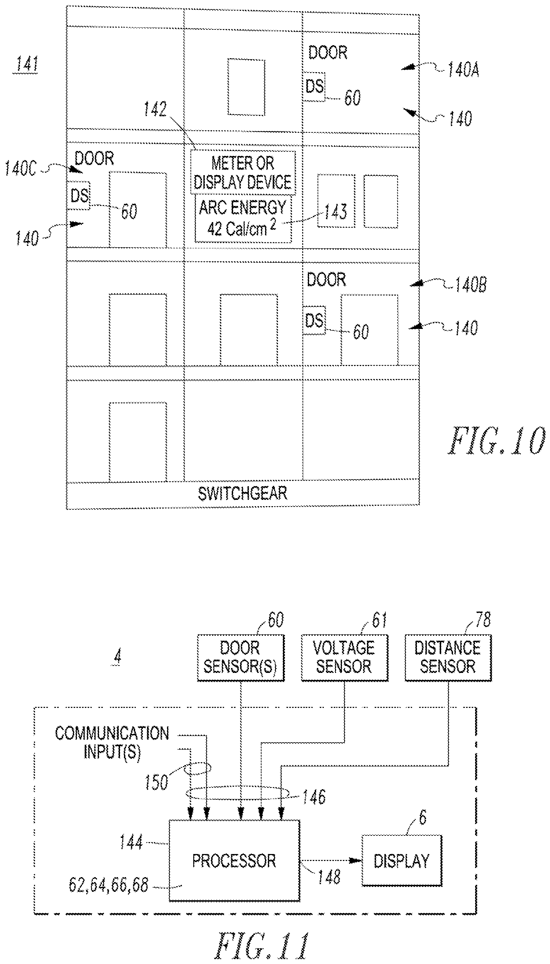

Figure 3 shows a representation of the one line diagram 18 of Figure 2 displaying the different dynamic arc flash incident energy values 20 at the number of different locations 22 of the system 12. For example, each of the different energy values 20 may be calculated and displayed by the device 14 of Figure 2, or each of the different energy values 20 may be calculated by a device similar to the device 4 of Figure 1 and communicated (e.g., employing a communication bus or network to the communication input 150 of Figure 11) to the device 14 of Figure 2 for reception and display. Each such device 4,14 may be distributed throughout the system 12, with one device at each of the number of different locations 22 of the system 12. Each of the different energy values 20 is a calculated incident energy for a corresponding one of the different locations 22 (e.g., different power circuit zones).

The devices 4,14 of Figures 1 and 2 are preferably configured for bolted fault current ($I_{bf}$) (e.g., maximum short circuit current) for each of the different locations 22 (e.g., different power circuit zones) of a system, such as 12. For example and without limitation, in the system 24 of Figure 3, there are two utility sources 26 (U1), 28 (U2), and two generators 30 (G1), 32 (G2), each of which has a corresponding circuit breaker 34,36,38,40. This forms three example zones 42 (zone 1.1), 44 (zone 2.1) and 46 (zone 3.I) separated by two example tie circuit breakers 48,50. A plurality of branch circuit breakers 52 are electrically connected downstream of upper zones 42,44,46, and three example downstream zones 54 (zone 1.1.1.I), 56 (zone 2.I.1.I)and 58 (zone 3.I.2.I) are formed.

For example and without limitation, for zone 42 (zone 1.I), the bolted fault current ($I_{bf}$) is entered for various possible configurations of the utility sources 26,28 and the generators 30,32 (not all of which may be listed in this non-limiting example):

$I_{bf}$ (U1 only) :::: 60 kA (e.g., calculated from the short circuit capability of the utility source U1 and the impedance from that source to the zone 42),
$I_{bf}$ (U2 only)= 40 kA,
$I_{bf}$ (U1 + U2) = 100 kA (e.g., calculated from the short circuit capability of both sources U1 ,U2 to the zone 42),
$I_{bf}$(G1 only) = 10 kA,
$I_{bf}$ (G2 only) = 10 kA,

$$I_{bf}(U1 + U2 + G1) = 110\,kA,$$

$$I_{bf}(U1 + U2 + G2) = 110\,kA,$$

and

$$I_{bf}(U1 + U2 + G1 + G2) = 120\,kA.$$

For example and without limitation, for downstream zone 54 (zone 1. 1.1.1), the bolted fault current ($I_{bf}$) is entered for various possible configurations of the utility sources 26,28 and the generators 30,32 (not all of which may be listed in this non-limiting example):

$I_{bf}$ (U1 only) = 42 kA,
$I_{bf}$ (U2 only) = 43 kA,
$I_{bf}$ (U1 + U2):::: 85 kA,
$I_{bf}$ (G1 only) = 5 kA,
$I_{hf}$ (G2 only) :::: 5 kA,

$$I_{bf}(U1 + U2 + G1) = 90\,kA,$$

and

$$I_{bf}(U1 + U2 + G1 + G2) = 95\,kA.$$

The arcing current ($I_3$) at each location (e.g, zone) is calculated from Equation 1:

$$\log I_a = K + 0.662\log I_{bf} + 0.0966V + 0.000526G + 0.5588V\log I_{bf} - 0.00304G\log I_{bf}$$

$$(Eq.\ 1)$$

wherein:

$I_3$ is arcing current (kA);

K is -0.153 for open enclosure configurations (e.g., open air equipment or a worker working on a cable), or is -0.097 for box configurations (e.g., switchgear; load center; panelboard);

$I_{bf}$ is bolted fault current (kA);

V is measured system voltage (kV) from a voltage sensor 61 (Figure 11 for the location); and

G is a gap between conductors and is 32 mm for switchgear and 25 mm for a panelboard and is predetermined for each location.

The normalized incident energy ($E_n$) is calculated from Equation 2:

$$\log E_n = K_1 + K_2 + 1.081 \log I_a + 0.0011 G$$

$$(Eq.\ 2)$$

wherein:

$K_1$ is -0.792 for open enclosure configurations, or is -0.555 for box enclosure configurations; and

$K_2$ is 4 for ungrounded and high resistance grounded systems, or is -0.1 13 for grounded systems and is predetermined for each location.

The final incident energy (E) ($J/cm^2$) at each location is calculated from Equation 3:

$$E = 4.184 C_f E_n (t/0.2)(610^X/D^X)$$

$$(Eq.\ 3)$$

wherein:

Cr is 1.0 for voltages above 1 kV, and 1.5 for voltages below 1 kV;

X = distance exponent determined by the type of switchgear and system voltage;

t is the arcing interruption time (seconds) of a circuit interrupter (e.g., circuit breaker 52 of Figure 3) feeding each location as selected from three possible times:

$t_{max}$ = maximum fault interruption time,

$t_{ZSI}$ = a smaller interruption time whenever Zone Selective Interlocking (ZSI) is enabled for the location, and

$t_{ARMS}$ = the fastest interruption time whenever Arc Reduction Maintenance System (ARMS) is enabled for the location; and

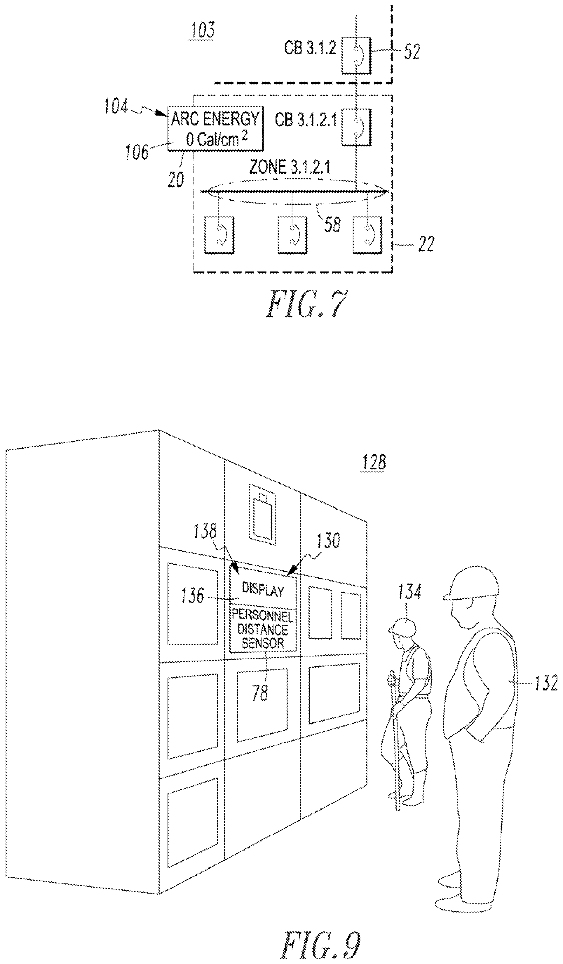

D is sensed distance (mm) from a possible arcing point in the location to a person using a distance sensor 78 (Figure 9).

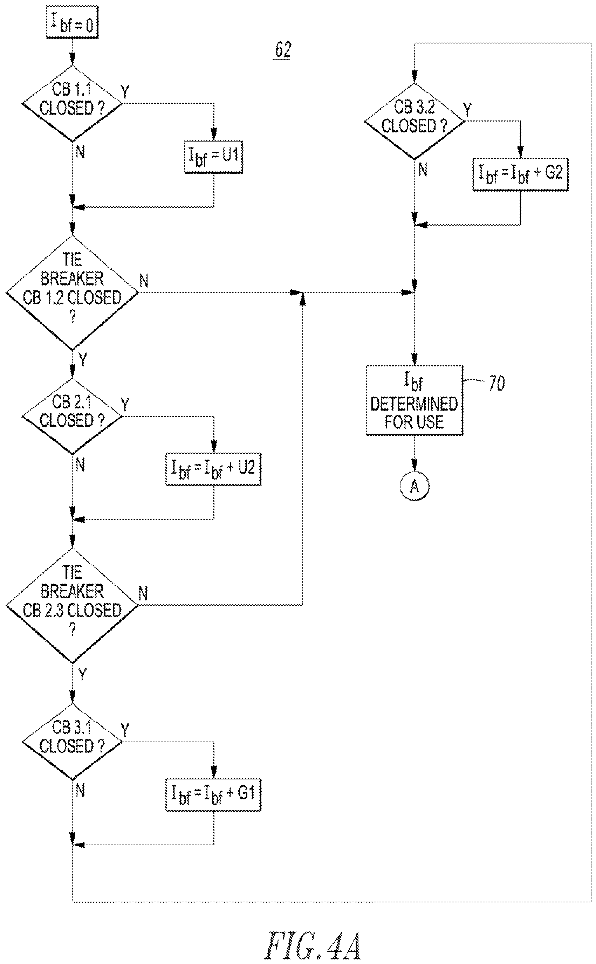

Figures 4A-4D show example routines 62,64,66,68 executed by the meter or display device 4 of Figure 1. These example routines correspond to the example zone 42 (zone 1.1) of Figure 3. Persons of ordinary skill in the art will appreciate that other suitable routines can be provided for any of the other example zones 44,46,54,56,58 of Figure 3.

Referring to Figure 4A, the example routine 62 determines the bolted fault current ($I_{bf}$) at 70 based upon the open or dosed states of various circuit breakers 34,36,38,40,48,50 operatively associated with the example zone 42 (zone 1.1) of Figure 3. Communication of these open or closed circuit breaker states and communication of the availability of the various power sources 26,28,30,32 is discussed, below, in connection with Figure 11. The routine 52 determines the bolted fault current for the different power sources (e.g., U1,U2,G1,G2 of Figure 3) that are available (e.g., based, in part, upon the open or closed states of the various circuit breakers operatively associated with the example zone 42 (zone 1.1)).

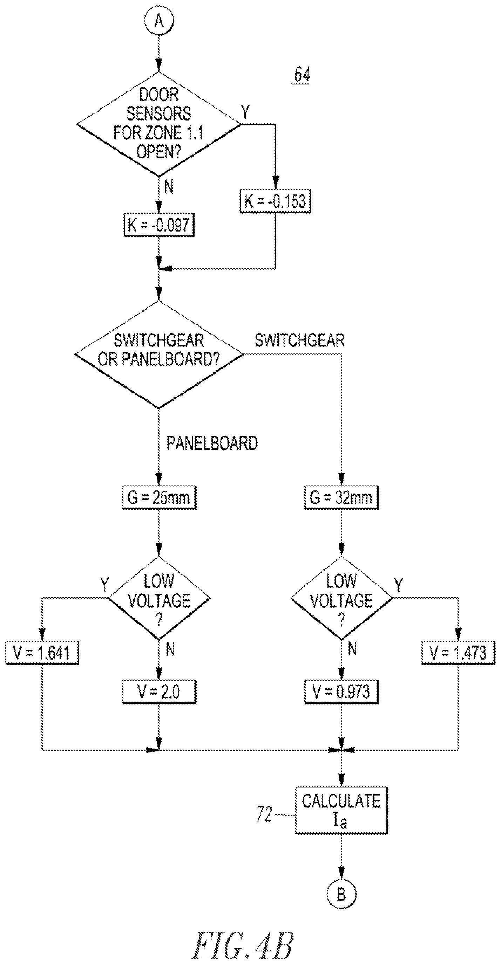

As shown in Figure 4B, the example routine 64 determines the arcing current ($I_3$) at 72 employing Equation 1 based upon the switchgear configuration, whether the corresponding zone includes switchgear or a panelboard, and whether the corresponding zone has a low voltage (less than 1 kV). The example routine 64 is suitably configured for the example zone 42, which can include a panelboard of switchgear, and which can employ a low voltage or medium voltage.

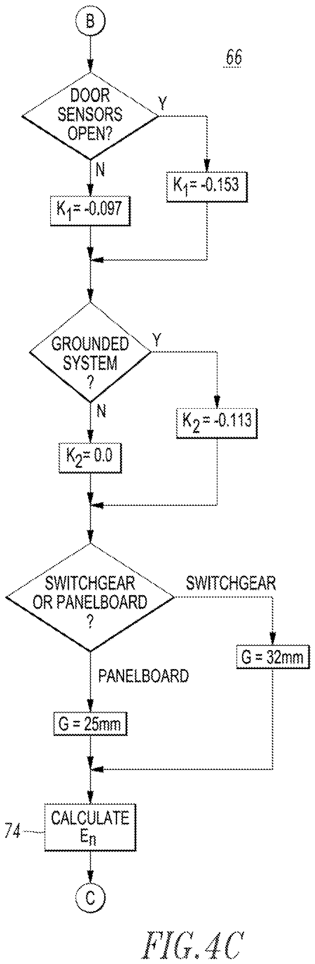

Referring to Figure 4C, the example routine 66 determines the normalized incident energy ($E_n$) at 74 employing Equation 2 based upon the type of enclosure, whether the corresponding zone is a grounded or an ungrounded system, and whether the corresponding zone includes switchgear or a panelboard.

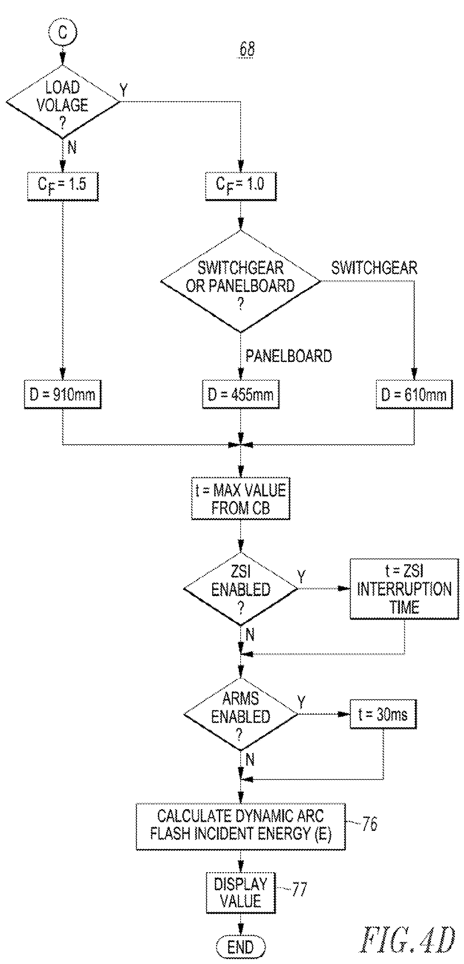

Figure 4D shows the example routine 68 to determine the final incident energy (E) at 76 employing Equation 3 based upon whether the system is low voltage, whether there is switchgear or a panelboard, and the arcing time for a circuit breaker (with ZSI and ARMS both being disabled), ZSI being enabled, or ARMS being enabled. The final incident energy (E) is displayed at 77. Communication of ZSI or ARMS being enabled is discussed, below, in connection with Figure 11. This example employs standard values for distance for switchgear, panelboards and for low or medium voltage applications. Alternatively, those distances could be dynamic as input from a personnel distance sensor or range finder 78 (Figure 9), if available, or else can default to the standard distance, as shown. The arcing interruption time is selected from the group consisting of (1) $t_{max}$ which is a maximum fault interruption time for the circuit interrupter, (2) $t_{ZSI}$ which less than $t_{max}$ whenever ZSI is enabled for the corresponding power circuit zone, and (3) $t_{ARMS}$ which is less than $t_{ZSI}$ whenever ARMS is enabled for the corresponding power circuit zone.

Another variable factor is system voltage. High line voltage, sagging line voltage, and swells in the voltage can affect the incident energy potential Instead of using standard values of line voltage, the actual voltage value is sensed by the voltage sensor 61 (Figure 11), is used in the calculation, and is optionally displayed.

In Figures 4B-4D, various values of interest (e.g., lbf; switchgear/panelboard; grounded/ungrounded) can be predetermined (or configured) and be stored by the example meter or display device 4 for the disclosed calculations.

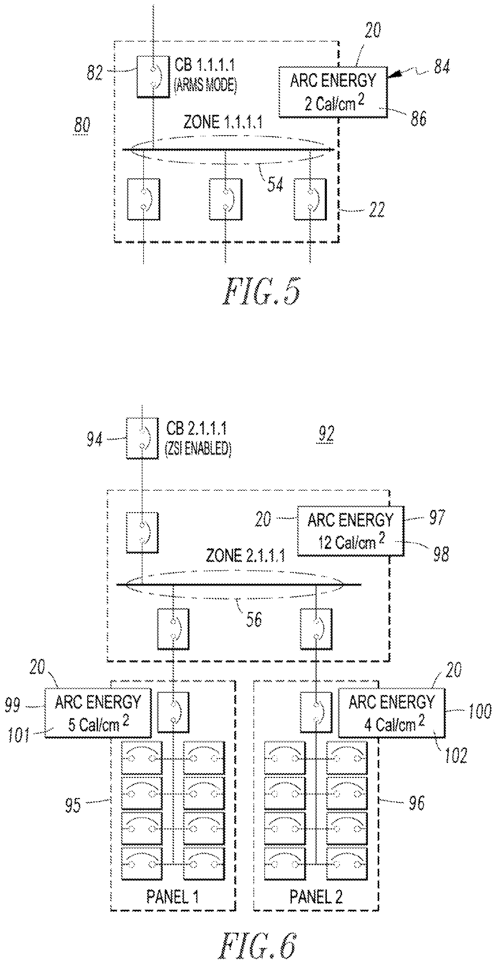

Figure 5 shows a representation 80 of a portion of a one line diagram similar to a portion of the one line diagram 18 of Figure 2 except showing circuit breaker 82 (CB 1.1.1.1) in an ARMS mode and a display 84 showing a relatively lower value 86 of potential incident energy for zone 54 (zone 1.1.1.1). For example, there is the ARMS protection mode that can be enabled on the circuit breaker 82. This protection mode can be a special hardware feature in the circuit breaker trip unit (not shown) or can be a lower instantaneous setting of the protective relay (not shown) or the electronic trip unit (not shown) of the circuit breaker 82. When the circuit breaker 82 is in this mode, the downstream distribution system will be at a relatively lower value of incident energy potential.

Referring to Figure 6, a representation 92 is shown of a portion of a one line diagram similar to a portion of the one line diagram 18 of Figure 2 except showing circuit breaker 94 (CB 2.1.1.1) that has ZSI enabled with the downstream zone 56 (zone 2.1.1.1) and the two panelboards 95,96. A display 97 shows a relatively lower value 98 of potential incident energy for the zone 56. Also, displays 99,100 show relatively lower values 101 ,102 of potential incident energy for the panelboards 95,96, respectively.

Figure 7 shows a representation 103 of a portion of a one line diagram similar to a portion of the one line diagram 18 of Figure 2 except showing circuit breaker 52 (CB 3. 1.2) that is opened. A display 104 shows a relatively lower value 106 of potential incident energy for zone 58 (zone 3.1.2.1).

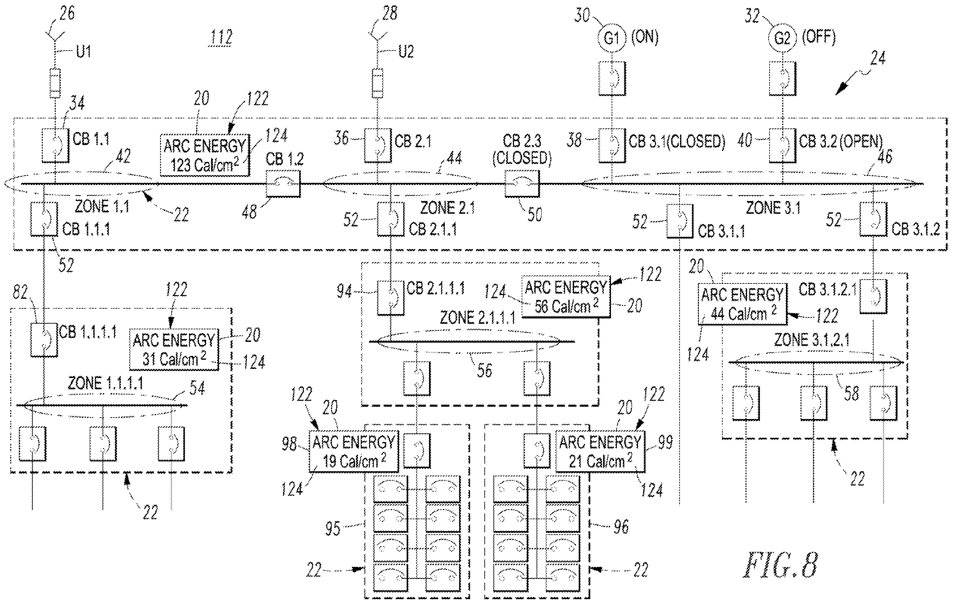

Referring to Figure 8, a representation 112 is shown of a one line diagram similar to the one line diagram 18 of Figure 2 except that the generator 30 (G1) is turned on and the corresponding circuit breaker 38 and tie circuit breaker 50 are closed and paralleled with the utility feeds 26,28 when the tie circuit breaker 48 is also closed. Displays 122 show relatively higher values 124 of potential arc flash incident energy throughout the electrical distribution system because of the generator 30.

For example, if generator G1 or G2 is started and if the generator is paralleled to main utility Ul or U2, then this could raise the level of incident energy. Also, if multiple generators G1,G2 are paralleled together then the level of incident energy will rise with the number of generators that are paralleled which is another dynamic feature. As another example, if utility U1 or U2 is off and the system is only running on one generator G1 or G2, then the incident energy level will decrease if the generator has a lower level of symmetrical fault current capability.

Figure 9 shows switchgear 128 including a meter or display device 130, which can be the same as of similar to the meter or display devices 4,14 of Figures 1 and 2. The device 130 includes one or more of the personnel distance sensor or range finder (PDS) 78. In this example, one person (e.g., without limitation, a maintenance worker) 132 is standing very close to the switchgear 128 and another person 134 is standing some distance further away. The personnel distance sensor 78 senses the distance to the closest person 132. The device 130 includes a display 136 showing the incident energy value 138 that corresponds to the sensed distance the closest person 132 is away from the switchgear 128. The sensor 78 is located on the front of the switchgear 128 and is calibrated to a safe distance out from the switchgear. When a person walks into the location (e.g., zone) corresponding to the switchgear 128, the device 130 automatically calculates and displays a new value of the incident energy value 138 for the distance that person is away from the switchgear 128.

Referring to Figure 10, if a person opens one of the switchgear doors 140 of switchgear 141 (or panelboard doors), then the person is at a much higher risk of being exposed to the incident energy should there be an arc flash incident. The status of whether the doors 140 are open or closed can be input by a meter or display device 142, which can be the same as or similar to the meter or display devices 4,14 of Figures 1 and 2, that performs the dynamic incident energy calculation. The device 142 is configured to know where the various doors 140 are located and where on a one line diagram (e.g., Figure 3) to do the dynamic calculation of the potential incident energy in a corresponding location (e.g., zone).

The location of a person (e.g., 132 of Figure 9) with respect to the switchgear doors 140 can also be an input to the meter or display device 142 using the personnel distance sensor 78 of Figure 9. That distance will also affect the value of potential incident energy. Hence, instead of using typical values as found in the IEEE 1584 standard, the actual working distance can be used. The sensed distance (D) using a distance sensor 78 is shown in Equation 3.

The switchgear 141 includes a number of the door sensors (DS) 60 for the number of doors 140. Using Equation 1 or the routine 64 of Figure 4B, the meter or display device 142 can calculate different values of the potential incident energy based upon the corresponding door 140 being open or closed. The switchgear doors 140 are monitored and that information is input by the meter or display device 142. For example, when door 140A is opened, this door has an empty cell behind it and there is no change to the calculated and displayed incident energy value 143. For example and without limitation, if door 140B is opened, then the calculated incident energy value goes into effect. A warning alarm is displayed (e.g., without limitation, displayed energy values are in red) or the display will flash the energy value.

Figure 11 shows a block diagram of the meter or display device 4 of Figure 1, which is for one or more power circuit zones, such as 42,44,46 of Figure 3. The device 4 includes a processor 144 having a plurality of dynamic inputs 146, the routines 62,64,66,68 of Figures 4A-4D, and an output 148. The routines 62,64,66,68 input the dynamic inputs 146, calculate the incident energy (at 76 of Figure 4D) of one of the power circuit zones, and output (at 77 of Figure 4D) the output 148. The display 6 displays at least the calculated incident energy from the processor output 148.

The dynamic inputs 146 include one or more of: (1) a communication input 150 that inputs whether a utility power source (e.g., U1 or U2 of Figure 3) is unavailable and a number of generators (e.g., G1 or G2 of Figure 3) are available (e.g., a generator is started and a corresponding circuit breaker, such as 38 or 40 of Figure 3, is closed); (2) the communication input 150 that inputs whether a plurality of different power sources (e.g., U1,U2,G1,G2 of Figure 3) are available (e.g., a corresponding circuit breaker, such as 34 or 36 of Figure 3, is closed); (3) the communication input 150 that inputs a protection mode of a circuit interrupter, a trip unit or a protective relay of a power circuit zone (e.g., circuit breaker 82 for zone 54 (zone 1.1.1. 1); (4) the communication input 150 that inputs whether a generator (e.g., G1,G2 of Figure 3) is started and paralleled to a utility power source (e.g., U1,U2 of Figure 3 based upon the state of the circuit breakers 34,36,38,40,48,50); (5) the communication input 150 that inputs whether a plurality of generators (e.g., G1,G2 of Figure 3) are started and paralleled together (based upon the state of the circuit breakers 38,40,50 of Figure 3); (6) the communication input 150 that inputs whether a ZSI system is enabled of a circuit interrupter, a trip unit or a protective relay (e.g., circuit breaker 82 of Figure 3) of a corresponding power circuit zone; (7) the door sensor 60 that senses an open door 140 (Figure 10) of the example switchgear 141 of a corresponding power circuit zone; (8) the voltage sensor 61 that senses a system voltage of a corresponding power circuit zone; and (9) the distance sensor 78 that senses a distance between a person and the example switchgear 128 of a corresponding power circuit zone.

The example communication input 150 can be, for example and without limitation, a network communication controller that, for example and without limitation, interconnects the processor 144 with one or more of the circuit breakers, such as 34,36,38,48,50,52 of Figure 3, or with other suitable interlaces to the power sources 26,28,30,32 of Figure 3, using a suitable communication bus or communication network (not shown). For example, the network communication controller can poll or query whether ZSI or ARMS is enabled, or whether a particular circuit breaker is open or closed.

The disclosed meter or display devices 2,14,130,142 calculate actual real time arc flash incident energy values based upon plural dynamic inputs and display a number of dynamic values or a one line diagram that shows locations (e.g., zones) that are affected by changes in the dynamic inputs. These devices dynamically calculate and display the present value of the arc flash incident energy. A static value may not be the right value at any one instant in time and there are many factors in the incident energy value that change when electrical distribution system parameters change.

While for clarity of disclosure reference has been made herein to the example displays, such as 6 or 16, for displaying the example dynamic value 8 and/or the example one line diagram 18, it will be appreciated that such information may be stored, be printed on hard copy, be computer modified, or be combined with other data. All such processing shall be deemed to fall within the terms "display" or "displaying" as employed herein,

While specific embodiments of the disclosed concept have been described in detail, it will be appreciated by those skilled in the art that various modifications and alternatives to those details could be developed in light of the overall teachings of the disclosure according to the scope of the appended claims. Accordingly, the particular arrangements disclosed are meant to be illustrative only and not limiting as to the scope of the disclosed concept which is to be given the full breadth of the claims appended.

**EP 3 108 558 B1**

**Claims**

1. A display device (4; 14; 130; 142) for at least one power circuit zone (42; 54; 56; 58), said device comprising:

   a processor (144) including a plurality of inputs including one or more dynamic inputs (146) collected in real time, a routine (62; 64; 66; 68) and an output (148), the routine being structured to input the plurality of inputs, calculate (76) in real time incident energy of one power circuit zone of the at least one power circuit zone based on the plurality of inputs, and output (77) at least the calculated incident energy;
   a display (6) structured to display at least the calculated incident energy (8) from the output of said processor; and
   a distance sensor (78) structured to sense in real time an actual distance between a person (132) and a switchgear (128) or a panelboard (95; 96) of said one power circuit zone of the at least one power circuit zone and to output the sensed actual distance as one of said dynamic inputs, the sensed actual distance being a distance from a possible arcing point in said one power circuit zone of the at least one power circuit zone to the person;
   wherein the routine is structured to use the sensed distance to calculate the incident energy; and
   wherein the plurality of inputs comprises a system voltage of said one power circuit zone of the at least one power circuit zone, a normalized incident energy, an arcing interruption time of a circuit interrupter feeding said one power circuit zone of the at least one power circuit zone, the sensed actual distance, and a distance exponent which is a function of a type of switchgear (128) and the system voltage.

2. The display device (4) of claim 1 wherein said display is further structured to display a dynamic value (8) representing the calculated incident energy.

3. The display device (4) of claim 1 wherein one of said dynamic inputs includes a communication input (150) that is configured to input a protection mode of a circuit interrupter, a trip unit or a protective relay of the at least one power circuit zone.

4. The display device (4) of claim 1 wherein one of said dynamic inputs includes a communication input (150) that is configured to input whether a Zone Selective Interlocking, ZSI, system is enabled of a circuit interrupter, a trip unit or a protective relay of the at least one power circuit zone.

5. The display device (4) of claim 1 wherein one of said dynamic inputs includes a communication input (150) that is configured to input whether a utility power source (26; 28) is unavailable and a number of generators (30; 32) are available.

6. The display device (4) of claim 1 wherein one of said dynamic inputs includes a door sensor (60) that is configured to sense an open door (140) of switchgear (141) or a panelboard (95; 96) of said one power circuit zone of the at least one power circuit zone.

7. The display device (4) of claim 1 wherein one of said dynamic inputs includes a voltage sensor (61) that is configured to sense the system voltage of said one power circuit zone of the at least one power circuit zone.

8. The display device (4) of claim 1 wherein said routine is configured (62,64,66) for at least one of:

   a predetermined bolted fault current, $I_{bf}$, from each of a plurality of different power sources (26; 28; 30; 32) that power said one power circuit zone of the at least one power circuit zone,
   whether said one power circuit zone of the at least one power circuit zone is switchgear (2) or a panelboard (95; 96), and
   whether said one power circuit zone of the at least one power circuit zone is grounded or ungrounded.

9. The display device (4) of claim 1 wherein the or more dynamic inputs include a communication input (150) that is configured to input whether a plurality of different power sources (26; 28; 30; 32) is available; and wherein said routine is further structured to calculate (70) the bolted fault current for said different power sources that are available.

10. The display device (4) of claim 1 wherein said routine is further structured to calculate (72) arcing current, $I_a$, from:

$$logI_a = K + 0.662logI_{bf} + 0.0966V + 0.000526G + 0.5588VlogI_{bf} - 0.00304GlogI_{bf}$$

wherein:

$I_a$ is said calculated arcing current;
K is -0.153 for an open enclosure configuration, or is -0.097 for a box configuration;
$I_{bf}$ is bolted fault current;
V is system voltage of said one power circuit zone of the at least one power circuit zone; and
G is a gap between conductors of said switchgear or said panelboard.

11. The display device (4) of claim 10 wherein said routine is further structured to calculate (74) the normalized incident energy, $E_n$, from:

$$logE_n = K_1 + K_2 + 1.081logI_a + 0.0011G$$

wherein:

$K_1$ is -0.792 for the open enclosure configuration, or is -0.555 for the box configuration; and
$K_2$ is 0 for the switchgear or the panelboard being an ungrounded or high resistance grounded system, or is -0.113 for the switchgear or the panelboard being a grounded system.

12. The display device (4) of claim 11 wherein said routine is further structured to calculate (76) final incident energy , E, from:

$$E = 4.184C_fE_n(t/0.2)(610^X/D^X)$$

wherein:

Cf is 1.0 for the system voltage being above 1 kV, or is 1.5 for the system voltage being below 1 kV;
X is the distance exponent;
t is the arcing interruption time of the circuit interrupter feeding said one power circuit zone of the at least one power circuit zone; and
D is either the sensed actual distance or a predetermined distance from a possible arcing point in said one power circuit zone of the at least one power circuit zone to a person.

13. The display device (4) of claim 12 wherein said arcing interruption time is selected from the group consisting of:

$t_{max}$ which is a maximum fault interruption time of a circuit interrupter for said one power circuit zone of the at least one power circuit zone,
$t_{ZSI}$ which less than $t_{max}$ whenever Zone Selective Interlocking, ZSI, is enabled for said one power circuit zone of the at least one power circuit zone, and
$t_{ARMS}$ which is less than tzsi whenever an Arc Reduction Maintenance System, ARMS, is enabled for said one power circuit zone of the at least one power circuit zone.

14. A display device (4) of claim 1, wherein said plurality of inputs further includes one or more static inputs.

**Patentansprüche**

1. Anzeigevorrichtung (4; 14; 130; 142) für mindestens eine Leistungskreiszone (42; 54; 56; 58), wobei die Vorrichtung Folgendes umfasst:

einen Prozessor (144), der eine Vielzahl von Eingaben, einschließlich einer oder mehrerer dynamischer Eingaben(146), die in Echtzeit gesammelt werden, eine Routine (62; 64; 66; 68) und einen Ausgabe (148) einschließt, wobei die Routine so strukturiert ist, dass sie die Vielzahl von Eingaben eingibt, in Echtzeit die Einfallsenergie einer Leistungskreiszone der mindestens einen Leistungskreiszone basierend auf der Vielzahl von Eingaben berechnet (76) und mindestens die berechnete Einfallsenergie ausgibt (77);

eine Anzeige (6), die strukturiert ist, mindestens die berechnete Einfallsenergie (8) aus der Ausgabe des Prozessors anzuzeigen; und

einen Abstandssensor (78), der strukturiert ist, in Echtzeit einen tatsächlichen Abstand zwischen einer Person (132) und einer Schaltanlage (128) oder einer Schalttafel (95; 96) der einen Leistungskreiszone der mindestens einen Leistungskreiszone zu erfassen und den erfassten tatsächlichen Abstand als eine der dynamischen Eingaben auszugeben, wobei der erfasste tatsächliche Abstand ein Abstand von einem möglichen Lichtbogenpunkt in der einen Leistungskreiszone der mindestens einen Leistungskreiszone zu der Person ist;

wobei die Routine strukturiert ist, den erfassten Abstand zur Berechnung der Einfallsenergie zu verwenden; und wobei die Vielzahl von Eingaben eine Systemspannung der einen Leistungskreiszone der mindestens einen Leistungskreiszone, eine normalisierte Einfallsenergie, eine Lichtbogenunterbrechungszeit eines Stromkreisunterbrechers, der die eine Leistungskreiszone der mindestens einen Leistungskreiszone speist, den erfassten tatsächlichen Abstand und einen Abstandsexponenten umfasst, der eine Funktion einer Schaltanlage (128) und der Systemspannung ist.

2. Anzeigevorrichtung (4) nach Anspruch 1, wobei die Anzeige ferner strukturiert ist, einen dynamischen Wert (8) anzuzeigen, der die berechnete Einfallsenergie darstellt.

3. Anzeigevorrichtung (4) nach Anspruch 1, wobei eine der dynamischen Eingaben eine Kommunikationseingabe (150) einschließt, die konfiguriert ist, einen Schutzmodus eines Stromkreisunterbrechers, einer Auslöseeinheit oder eines Schutzrelais der mindestens einen Leistungskreiszone einzugeben.

4. Anzeigevorrichtung (4) nach Anspruch 1, wobei eine der dynamischen Eingaben eine Kommunikationseingabe (150) einschließt, die konfiguriert ist, einzugeben, ob ein System zur zonenselektiven Verriegelung (Zone Selective Interlocking, ZSI) eines Stromkreisunterbrechers, einer Auslöseeinheit oder eines Schutzrelais der mindestens einen Leistungskreiszone aktiviert ist.

5. Anzeigevorrichtung (4) nach Anspruch 1, wobei eine der dynamischen Eingaben eine Kommunikationseingabe (150) einschließt, die konfiguriert ist, einzugeben, ob eine Netzleistungsquelle (26; 28) nicht verfügbar ist und eine Anzahl von Generatoren (30; 32) verfügbar ist.

6. Anzeigevorrichtung (4) nach Anspruch 1, wobei eine der dynamischen Eingaben einen Türsensor (60) einschließt, der konfiguriert ist, eine offene Tür (140) der Schaltanlage (141) oder einer Schalttafel (95; 96) der einen Leistungskreiszone der mindestens einen Leistungskreiszone zu erfassen.

7. Anzeigevorrichtung (4) nach Anspruch 1, wobei eine der dynamischen Eingaben einen Spannungssensor (61) einschließt, der konfiguriert ist, die Systemspannung der einen Leistungskreiszone der mindestens einen Leistungskreiszone zu erfassen.

8. Anzeigevorrichtung (4) nach Anspruch 1, wobei die Routine konfiguriert ist (62, 64, 66) für mindestens eines von Folgendem:

einen vorbestimmten verschraubten Fehlerstrom, $I_{bf}$ aus jeder von einer Vielzahl von unterschiedlichen Leistungsquellen (26; 28; 30; 32), welche die eine Leistungskreiszone der mindestens einen Leistungskreiszone versorgen,

ob die eine Leistungskreiszone der mindestens einen Leistungskreiszone die Schaltanlage (2) oder eine Schalttafel (95; 96) ist, und

ob die eine Leistungskreiszone der mindestens einen Leistungskreiszone geerdet oder ungeerdet ist.

9. Anzeigevorrichtung (4) nach Anspruch 1, wobei die oder mehrere dynamische Eingaben eine Kommunikationseingabe (150) einschließen, die konfiguriert ist, einzugeben, ob eine Vielzahl von unterschiedlichen Leistungsquellen (26; 28; 30; 32) verfügbar ist; und wobei die Routine ferner strukturiert ist, den verschraubten Fehlerstrom für die verschiedenen verfügbaren Leistungsquellen zu berechnen (70).

10. Anzeigevorrichtung (4) nach Anspruch 1, wobei die Routine ferner strukturiert ist, Lichtbogenstrom, $I_a$, zu berechnen

(72) aus:

$$\log I_a = K + 0{,}662 \log I_{bf} + 0{,}0966V + 0{,}000526G + 0{,}5588V\log I_{bf} - 0.00304G\log I_{bf}$$

wobei:

$I_a$ der berechnete Lichtbogenstrom ist;
K gleich -0,153 für eine offene Gehäusekonfiguration oder gleich -0,097 für eine Boxkonfiguration ist;
$I_{bf}$ der verschraubte Fehlerstrom ist;
V die Systemspannung der einen Leistungskreiszone der mindestens einen Leistungskreiszone ist; und
G ein Spalt zwischen Leitern der Schaltanlage oder der Schalttafel ist.

11. Anzeigevorrichtung (4) nach Anspruch 10, wobei die Routine ferner strukturiert ist, die normalisierte Einfallsenergie, $E_n$, zu berechnen (74) aus:

$$\log E_n = K_1 + K_2 + 1{,}081 \log I_a + 0{,}0011G$$

wobei:

$K_1$ gleich -0,792 für die offene Gehäusekonfiguration oder gleich -0,555 für die Boxkonfiguration ist; und
$K_2$ gleich 0 ist, wenn die Schaltanlage oder die Schalttafel ein ungeerdetes oder hochohmig geerdetes System ist, oder gleich -0,113 ist, wenn die Schaltanlage oder die Schalttafel ein geerdetes System ist.

12. Anzeigevorrichtung (4) nach Anspruch 11, wobei die Routine ferner strukturiert ist, eine endgültige Einfallsenergie, E, zu berechnen (76) aus:

$$E = 4{,}184 C_f E_n (t/0{,}2)(610^X/D^X)$$

wobei:

Cf gleich 1,0 ist, wenn die Netzspannung über 1 kV liegt; oder gleich 1,5 ist, wenn die Netzspannung unter 1 kV liegt;
X der Abstandsexponent ist;
t die Lichtbogenunterbrechungszeit des Stromkreisunterbrechers ist, der die eine Leistungskreiszone der mindestens einen Leistungskreiszone speist; und
D entweder der erfasste tatsächliche Abstand oder ein vorbestimmter Abstand von einem möglichen Lichtbogenpunkt in der einen Leistungskreiszone der mindestens einen Leistungskreiszone zu einer Person ist.

13. Anzeigevorrichtung (4) nach Anspruch 12, wobei die Lichtbogenunterbrechungszeit ausgewählt ist aus der Gruppe bestehend aus:

$t_{max}$, einer maximalen Fehlerunterbrechungszeit eines Stromkreisunterbrechers für die eine Leistungskreiszone der mindestens einen Leistungskreiszone,
$t_{ZSI}$, die kleiner als $t_{max}$ ist, wenn die zonenselektive Verriegelung, ZSI, für die eine Leistungskreiszone der mindestens einen Leistungskreiszone aktiviert ist, und
$t_{ARMS}$, die kleiner als $t_{ZSI}$ ist, wenn ein Lichtbogenreduzierungs-Wartungssystem, ARMS, für die eine Leistungskreiszone der mindestens einen Leistungskreiszone aktiviert ist.

14. Anzeigevorrichtung (4) nach Anspruch 1, wobei die Vielzahl von Eingaben ferner eine oder mehrere statische Eingaben einschließt.

**Revendications**

1. Dispositif d'affichage (4 ; 14 ; 130 ; 142) pour au moins une zone de circuit de puissance (42 ; 54 ; 56 ; 58), ledit dispositif comprenant :

   un processeur (144) comportant une pluralité d'entrées comportant une ou plusieurs entrées dynamiques (146) collectées en temps réel, une routine (62 ; 64 ; 66 ; 68) et une sortie (148), la routine étant structurée pour entrer la pluralité d'entrées, calculer (76) en temps réel une énergie incidente d'une zone de circuit de puissance de l'au moins une zone de circuit de puissance en fonction de la pluralité d'entrées, et délivrer en sortie (77) au moins l'énergie incidente calculée ;
   un affichage (6) structuré pour afficher au moins l'énergie incidente calculée (8) à partir de la sortie dudit processeur ; et
   un capteur de distance (78) structuré pour capter en temps réel une distance réelle entre une personne (132) et un appareillage de commutation (128) ou un tableau de distribution (95 ; 96) de ladite zone de circuit de puissance précitée de l'au moins une zone de circuit de puissance et pour délivrer en sortie la distance réelle captée en guise d'une desdites entrées dynamiques, la distance réelle captée étant une distance allant d'un point possible de production d'arc dans ladite zone de circuit de puissance précitée de l'au moins une zone de circuit de puissance jusqu'à la personne ;
   dans lequel la routine est structurée pour utiliser la distance captée pour calculer l'énergie incidente ; et
   dans lequel la pluralité d'entrées comprend une tension de système de ladite zone de circuit de puissance précitée de l'au moins une zone de circuit de puissance, une énergie incidente normalisée, un temps d'interruption de production d'arc d'un interrupteur de circuit alimentant ladite zone de circuit de puissance précitée de l'au moins une zone de circuit de puissance, la distance réelle captée, et un exposant de distance qui est une fonction d'un type d'appareillage de commutation (128) et de la tension de système.

2. Dispositif d'affichage (4) selon la revendication 1, ledit affichage étant en outre structuré pour afficher une valeur dynamique (8) représentant l'énergie incidente calculée.

3. Dispositif d'affichage (4) selon la revendication 1 dans lequel l'une desdites entrées dynamiques comporte une entrée de communication (150) qui est configurée pour entrer un mode de protection d'un interrupteur de circuit, d'une unité de déclenchement ou d'un relais de protection de l'au moins une zone de circuit de puissance.

4. Dispositif d'affichage (4) selon la revendication 1 dans lequel l'une desdites entrées dynamiques comporte une entrée de communication (150) qui est configurée pour indiquer en entrée si un système d'interverrouillage sélectif de zone, ZSI, est activé sur un interrupteur de circuit, une unité de déclenchement ou un relais de protection de l'au moins une zone de circuit de puissance.

5. Dispositif d'affichage (4) selon la revendication 1 dans lequel l'une desdites entrées dynamiques comporte une entrée de communication (150) qui est configurée pour indiquer en entrée si une source d'alimentation secteur (26 ; 28) est indisponible et si un certain nombre de générateurs (30 ; 32) sont disponibles.

6. Dispositif d'affichage (4) selon la revendication 1 dans lequel l'une desdites entrées dynamiques comporte un capteur de porte (60) qui est configuré pour capter une porte ouverte (140) d'un appareillage de commutation (141) ou d'un tableau de distribution (95 ; 96) de ladite zone de circuit de puissance précitée de l'au moins une zone de circuit de puissance.

7. Dispositif d'affichage (4) selon la revendication 1 dans lequel l'une desdites entrées dynamiques comporte un capteur de tension (61) qui est configuré pour capter la tension de système de ladite zone de circuit de puissance précitée de l'au moins une zone de circuit de puissance.

8. Dispositif d'affichage (4) selon la revendication 1 dans lequel ladite routine est configurée (62, 64, 66) pour au moins l'un parmi :

   un courant prédéterminé de défaut de court-circuit franc, $I_{bf}$, provenant de chacune parmi une pluralité de sources de puissance différentes (26 ; 28 ; 30 ; 32) qui alimentent en puissance ladite zone de circuit de puissance précitée de l'au moins une zone de circuit de puissance,
   le fait que ladite zone de circuit de puissance précitée de l'au moins une zone de circuit de puissance est un appareillage de commutation (2) ou un tableau de distribution (95 ; 96), et

le fait que ladite zone de circuit de puissance précitée de l'au moins une zone de circuit de puissance est reliée à la terre ou non reliée à la terre.

9. Dispositif d'affichage (4) selon la revendication 1 dans lequel la ou les entrées dynamiques comportent une entrée de communication (150) qui est configurée pour indiquer en entrée si une pluralité de sources de puissance différentes (26 ; 28 ; 30 ; 32) est disponible ; et dans lequel ladite routine est en outre structurée pour calculer (70) le courant de défaut de court-circuit franc pour lesdites sources de puissance différentes qui sont disponibles.

10. Dispositif d'affichage (4) selon la revendication 1 dans lequel ladite routine est en outre structurée pour calculer (72) un courant de production d'arc, $I_a$, à partir de :

$$\log I_a = K + 0{,}662 \log I_{bf} + 0{,}0966V + 0{,}000526G + 0{,}5588V \log I_{bf} - 0{,}00304G \log I_{bf}$$

dans lequel :

$I_a$ est ledit courant de production d'arc calculé ;
K vaut -0,153 pour une configuration d'enceinte ouverte, ou vaut -0,097 pour une configuration de boîtier ;
$I_{bf}$ est le courant de défaut de court-circuit franc ;
V est la tension de système de ladite zone de circuit de puissance précitée de l'au moins une zone de circuit de puissance ; et
G est un espace entre des conducteurs dudit appareillage de commutation ou dudit tableau de distribution.

11. Dispositif d'affichage (4) selon la revendication 10 dans lequel ladite routine est en outre structurée pour calculer (74) l'énergie incidente normalisée, $E_n$, à partir de :

$$\log E_n = K_1 + K_2 + 1{,}081 \log I_a + 0{,}0011G$$

dans lequel :

$K_1$ vaut -0,792 pour la configuration d'enceinte ouverte, ou vaut -0,555 pour la configuration de boîtier ; et
$K_2$ vaut 0 pour l'appareillage de commutation ou le tableau de distribution étant un système non relié à la terre ou relié à la terre à haute résistance, ou vaut -0,113 pour l'appareillage de commutation ou le tableau de distribution étant un système relié à la terre.

12. Dispositif d'affichage (4) selon la revendication 11 dans lequel ladite routine est en outre structurée pour calculer (76) l'énergie incidente finale, E, à partir de :

$$E = 4{,}184C_f E_n (t/0{,}2)(610^X/D^X)$$

dans lequel :

Cf vaut 1,0 pour la tension de système étant supérieure à 1 kV, ou vaut 1,5 pour la tension de système étant inférieure à 1 kV ;
X est l'exposant de distance ;
t est le temps d'interruption de production d'arc de l'interrupteur de circuit alimentant ladite zone de circuit de puissance précitée de l'au moins une zone de circuit de puissance ; et
D est soit la distance réelle captée soit une distance prédéterminée à partir d'un point possible de production d'arc dans ladite zone de circuit de puissance précitée de l'au moins une zone de circuit de puissance jusqu'à une personne.

13. Dispositif d'affichage (4) selon la revendication 12 dans lequel ledit temps d'interruption de production d'arc est choisi dans le groupe constitué par :

$t_{max}$ qui est un temps d'interruption maximal en cas de défaut d'un interrupteur de circuit pour ladite zone de circuit de puissance précitée de l'au moins une zone de circuit de puissance,

$t_{ZSI}$ qui est inférieur à $t_{max}$ chaque fois qu'un interverrouillage sélectif de zone, ZSI, est activé pour ladite zone de circuit de puissance précitée de l'au moins une zone de circuit de puissance, et

$t_{ARMS}$ qui est inférieur à $t_{ZSI}$ chaque fois qu'un système de maintien de réduction d'arc, ARMS, est activé pour ladite zone de circuit de puissance précitée de l'au moins une zone de circuit de puissance.

14. Dispositif d'affichage (4) selon la revendication 1, dans lequel ladite pluralité d'entrées comporte en outre une ou plusieurs entrées statiques.

*2*

SWITCHGEAR

*4*

METER OR
DISPLAY DEVICE

ARC ENERGY
42 Cal/cm$^2$

*8*

DISPLAY

*6*

*FIG.1*

_12_

SYSTEM

14

METER OR
DISPLAY DEVICE

18

ONE LINE DIAGRAM

22

ZONE | ZONE | ZONE

16

20

_FIG.2_

FIG.3

$I_{bf} = 0$

CB 1.1 CLOSED ? — Y → $I_{bf} = U1$
N

62

TIE BREAKER CB 1.2 CLOSED ? — N
Y

CB 2.1 CLOSED ? — Y → $I_{bf} = I_{bf} + U2$
N

TIE BREAKER CB 2.3 CLOSED ? — N
Y

CB 3.1 CLOSED ? — Y → $I_{bf} = I_{bf} + G1$
N

CB 3.2 CLOSED ? — Y → $I_{bf} = I_{bf} + G2$
N

$I_{bf}$ DETERMINED FOR USE — 70

A

*FIG.4A*

18

FIG.4B

FIG.4C

68

```
        (C)
         │
         ▼
      ╱LOAD  ╲        Y
     ╱ VOLAGE ╲──────────────────┐
     ╲   ?    ╱                   │
      ╲_____╱                    │
         │ N                      │
         ▼                        ▼
    ┌─────────┐            ┌─────────┐
    │ C_F = 1.5 │          │ C_F = 1.0 │
    └─────────┘            └─────────┘
         │                      │
         │                      ▼
         │            ╱SWITCHGEAR ╲  SWITCHGEAR
         │           ╱OR PANELBOARD╲──────────────┐
         │           ╲      ?       ╱              │
         │            ╲_____╱               │
         │                  │ PANELBOARD           │
         ▼                  ▼                      ▼
   ┌──────────┐     ┌──────────┐          ┌──────────┐
   │ D = 910mm │     │ D = 455mm │          │ D = 610mm │
   └──────────┘     └──────────┘          └──────────┘
         │                │                      │
         └────────────────┼──────────────────────┘
                          ▼
                 ┌──────────────┐
                 │ t = MAX VALUE │
                 │   FROM CB     │
                 └──────────────┘
                          │
                          ▼
                    ╱  ZSI   ╲    Y      ┌──────────────┐
                   ╱ ENABLED  ╲─────────▶│ t = ZSI       │
                   ╲    ?     ╱          │ INTERRUPTION  │
                    ╲_____╱           │    TIME       │
                         │ N             └──────────────┘
                         ▼◀──────────────────────┘
                    ╱  ARMS  ╲    Y      ┌──────────┐
                   ╱ ENABLED  ╲─────────▶│ t = 30ms  │
                   ╲    ?     ╱          └──────────┘
                    ╲_____╱                │
                         │ N◀────────────────┘
                         ▼
              ┌─────────────────────┐
              │ CALCULATE DYNAMIC ARC│── 76
              │ FLASH INCIDENT ENERGY (E)│
              └─────────────────────┘
                         │
                         ▼
                 ┌──────────┐
                 │ DISPLAY   │── 77
                 │ VALUE     │
                 └──────────┘
                         │
                         ▼
                     ( END )
```

*FIG.4D*

82 → CB 1.1.1.1
(ARMS MODE)

20

ARC ENERGY
2 Cal/cm$^2$

84

86

80

ZONE 1.1.1.1

54

22

*FIG.5*

94 → CB 2.1.1.1
(ZSI ENABLED)

92

20 — ARC ENERGY
12 Cal/cm$^2$

97

98

ZONE 2.1.1.1

56

20

99 — ARC ENERGY
5 Cal/cm$^2$

101

20

ARC ENERGY
4 Cal/cm$^2$

100

102

95

96

PANEL 1

PANEL 2

*FIG.6*

103

CB 3.1.2 — 52

104 → ARC ENERGY | CB 3.1.2.1

106 — 0 Cal/cm² 

20

ZONE 3.1.2.1

58

22

*FIG.7*

128

138 — 130

136 — DISPLAY

PERSONNEL DISTANCE SENSOR

78

134

132

*FIG.9*

FIG.8

EP 3 108 558 B1

_141_

DOOR

DS —60 ← —140A

← —140

_140C_ DOOR

142

DS —60

140 →

METER OR
DISPLAY DEVICE

ARC ENERGY
42 Cal/cm$^2$ —143

DOOR ← —140B

DS —60 ← —140

SWITCHGEAR

*FIG.10*

_4_

DOOR
SENSOR(S) —60

VOLTAGE
SENSOR —61

DISTANCE
SENSOR —78

COMMUNICATION
INPUT(S)

150

146

144 —

62,64,66,68 —

PROCESSOR

—148

DISPLAY —6

*FIG.11*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8493012 B
- US 2009105998 A
- EP 2662942 A
- US 2008036472 A1